# EUROPÄISCHE PATENTANMELDUNG

(11) **EP 0 597 346 A1**
(43) Veröffentlichungstag der Anmeldung: **18.05.1994**
(21) Anmeldenummer: 93117658.0
(22) Anmeldetag: 02.11.1993
(51) Int. Cl.: H05K 7/14, H01R 9/15

(54) **Baugruppenträger**

(30) Priorität: 10.11.1992 DE 4237865
(71) Anmelder: Licentia Patent-Verwaltungs-GmbH, D-60596 Frankfurt (DE)
(72) Erfinder: Steuernagel, Gernot, Dipl.-Ing., D-63075 Offenbach (DE); Bohnenberger, Willy, Dipl.-Ing., D-63533 Mainhausen (DE); Krüger, Joachim, Dipl.-Ing., D-63512 Hainburg (DE)
(74) Vertreter: Erbacher, Alfons, Dipl.-Ing.

(57) **Zusammenfassung**

Gegenstand der Erfidnung ist ein Baugruppenträger (1) für elektrische oder elektronische Baugrupen, die im Baugruppenträger (1) in Führungshaltern (5, 6) einsetzbar sind, die an Profilschienen befestigt sind, die zwischen Seitenwänden des Baugruppenträgers verlaufen. An den rückseitigen Profilschienen sind jeweils Metallschienen (16, 17) befestigt, die parallel zu den Profilschienen (3, 4) verlaufen und nahe an ihren äußeren Rändern je mit einer Profilschiene sowie nahe an ihren inneren Rändern mit Federleisten von Steckverbindern (7) verbunden sind, die an den rückwärigen Seiten des Baugruppenträgers für die Verbindung mit Messerleisten der Baugruppen angebracht sind. Es ist eine Betriebsspannungsverteileinrichtung (23; 39; 66) vorgesehen, die wenigstens eine mit einer der rückseitigen Metallschiene (16) verbundene, elektrisch isolierende Halterung (24; 40; 41; 65) aufweist, die wenigstens eine Platte (31; 42; 68) mit leitenden Einpreßstiften (32, 33, 34; 50, 51, 52) trägt. Die Einpreßstifte sind entsprechend dem zu verteilenden Potential mit Leiterebenen verbunden und neben den jeweils mit Betriebsspannung zu versorgenden Federleisten angeordnet sind. Die jeweiligen Leiterebenen sind mit wenigstens einer an der Platte angebrachten Anschlußstelle (59, 60, 61) für eine Leitung verbunden, die für den Anschluß an ein Stromversorgungsgerät bestimmt ist.

## Beschreibung

Die Erfindung bezieht sich auf Baugruppenträger für elektrische oder elektronische Baugruppen sowie deren Baugruppen, die im Baugruppenträger in Führungshaltern einsetzbar sind, die an Profilschienen befestigt sind, die zwischen Seitenwänden des Baugruppenträgers verlaufen, wobei an den rückseitigen Profilschienen Profilschienen befestigt sind, die parallel zu den Profilschienen verlaufen und nahe an ihren äußeren Rändern je mit einer Profilschiene sowie nahe an ihren inneren Rändern mit Federleisten von Steckverbindern verbunden sind, die an der rückwärtigen Seite des Baugruppenträgers für die Verbindung mit Messerleisten der Baugruppen angebracht sind.

Baugruppenträger für die Aufnahme insbesondere von Flachbaugruppen enthalten üblicherweise zwei Seitenwände, nahe an deren vier Ecken Profilschienen mit ihren Stirnseiten befestigt sind. Die Profilschienen tragen im Abstand eines genormten Rastermaßes Führungshalter, die Nuten enthalten, in die die Leiterplatten der Baugruppen mit ihren Rändern eingesetzt werden. Die Baugruppen sind somit als Steckbaugruppen ausgebildet, an deren rückwärtigen Enden jeweils Messerleisten von Steckverbindern angeordnet sind. Auf der rückwärtigen Seite des jeweiligen Baugruppenträgers sind in genormten Rastermaß Federleisten von Steckverbindern vorgesehen. Die Federleisten sind an ihren Enden jeweils an Metallschienen angeschraubt, die parallel zu den rückseitigen Profischienen verlaufen und nahe an ihren äußeren Enden mit diesen verbunden sind.

In der einschlägigen Literatur sind Vorschläge bekannt zum Anschluß von Versorgungs- und Signalleitungen an die Baugruppen und an die Steckverbinder.

So zeigen DE-U 89 09 325 und DE-OS 30 01 870 die üblicherweise verwendeten Rückwände von Baugruppenträgern, die als Baueinheit ausgefertigt sind. Da es sich hierbei um komplette Baueinheiten handelt sind diese teuer und aufwendig in der Produktion sowie an das jeweilige System gebunden. DE-OS 37 34 196 und DE-OS 18 08 280 zeigen Varianten der vorhergenannten Veröffentlichungen DE-U 89 09 325 und DE-OS 30 01 870, die auf eine bauliche Vereinfachung hinzielen. Im Falle von DE-OS 18 08 280 handelt es sich um einen modularen Aufbau der rückwärtigen Wand und im Falle DE-OS 37 34 196 um eine Ausführungsvariante der Stromzuführung. Auch hier liegt keine einfach zu produzierende, universell einsetzbare Struktur vor sondern kostenintensive, systemgebundene Einheiten.

US-PS 4 195 896 und DE-OS 22 18 017 zeigen Verbindungselemente zwischen Anschlußleisten zwischen Baugruppen untereinander einerseits und zwischen Versorgungsleisten und Baugruppen andererseits. Diese Schriften weisen jedoch die Nachteile auf, daß sie keine Vorschläge oder Lösungen mit Bezug auf die Plazierung oder die Befestigung der Kontaktleisten beinhalten und zusätzlich durch die normierten Verbindungen nicht flexibel einsetzbar sind. EP-OS 0 147 560 und (^{*} Artikel Norddeutscher Rundfunk ^{*}) zeigen weithin bekannte Durchführungen von Kabeln durch Gehäuseteile, Abschirmungen oder Abdekungen. Solche Verfahren sind teuer und aufwendig in der Produktion. Zudem handelt es sich genau betrachtet nur um eine Verlegung der Steckverbindung und damit nicht um eine universell einsetzbare, produktionseffiziente und einfache Konstruktion.

Der Erfindung liegt die Aufgabe zugrunde, die oben aufgezeigten Probleme zu lösen und weitere, erfindungsgemäße Vorteile zu erzielen. Für Baugruppenträger und Baugruppen der eingangs beschriebenen Art wird die Zufuhr der Betriebsspannungen und/oder Signale zu den rückwärtigen Anschlüssen flexibel ausgebildet und vereinfacht und damit die Möglichkeit geschaffen sie kosteneffektiv zu produzieren.

Die Aufgabe wird erfindungsgemäß durch die Merkmale im Patentanspruch 1 gelöst. Mit der im Anspruch 1 beschriebenen Einrichtung können mehrere Betriebsspannungen und/oder Signale mit einer einfach aufgebauten Einheit auf der Rückseite des Baugruppenträgers oder der Baugruppen angeschlossen werden.

In einer der bevorzugten Ausführungen können die Betriebsspannungen und/oder Signale mit kurzen Leitungen an nach hinten gerichtete Pfosten der Federleisten gelegt werden, die den Betriebsspannungs- und/oder Signalanschlüssen der Baugruppen zugeordnet sind. Der jeweilige Baugruppenträger bzw. die jeweilige Baugruppe muß nicht speziell an die Betriebsspannungs- oder Signalverteilungseinrichtung angepaßt werden, da diese ohne weiteres an üblicherweise vorhandenen Teilen befestigt werden kann. Die Betriebsspannungs-oder Signalverteilungseinrichtung läßt sich somit universell, einfach und kostengünstig verwenden, besonders in automatisierten Produktionsanlagen.

Bei einer weiteren, bevorzugten Ausführungsform trägt die Halterung einen Träger, z.B. eine Multilayer-Platte, die wenigstens zwei parallele Reihen von Einpreßstiften enthält, die in dem Raum hinter den Profilschienen über die Halterung hinausragen, wobei die Halterung einen freien Raum zwischen dem Träger, der Multilayer-Platte, und einem Bodenabschnitt aufweist, in den die Einpreßstifte ragen. Zwischen den in einer Reihe angeordneten Einpreßstiften können im freien Raum Verbindungsmittel für die Verteilung des gleichen Betriebspotentials angeordnet sein.

Die Einpreßstifte können insbesondere mit einer Hälfte in den Raum zwischen der Multilayer-Platte und dem Bodenabschnitt der Halterung ragen, wobei die für die Verteilung des gleichen Potentials vorgesehenen und in einer Reihe angeordneten Hälften der Einpreßstifte durch eine Aufsteckschiene miteinander verbunden sind.

Es ist auch möglich, die einer Betriebsspannung oder eines Signals zugeordneten Einpreßstifte als integralen Bestandteil einer flachen Schiene vorzusehen, von deren einer Schmalseite die Einpreßstifte vorspringen, wobei die Schiene im Raum zwischen dem Träger und dem Bodenabschnitt der Halterung angeordnet ist.

Im Raum zwischen dem Träger und dem Bodenabschnitt der Halterung lassen sich noch weitere Kontaktelemente und/oder Bauelemente wie z. B. Kondensatoren, Widerstände, Drosselspulen usw. bedarfsweise unterbringen.

Die Halterung ist vorzugsweise als U-förmige Profilschiene mit Nuten ausgebildet, die nahe an den freien Enden auf gleichem Niveau auf den Innenseiten angeordnet sind. In den einander zugewandten Nuten ist der Träger, z.B. eine Multilayer-Platte, angeordnet. Am Bodenabschnitt der Halterung sind Befestigungsmittel vorgesehen. In einem bevorzugten Ausführungsbeispiel umfassen sie Löcher für Schrauben, mit denen die Halterung an Metallschienen befestigt wird. Die Halterung kann insbesondere als Kunststoffspritzteil oder Kunststoffextrudierteil ausgebildet sein, d. h. sie kann kostengünstig hergestellt werden.

Die Erfindung wird im folgenden anhand bevorzugter Ausführungsbeispiele beschrieben, aus denen der Fachmann leicht erfindungsgemäße Abwandlungen ableiten kann. Insbesondere stützt sich die Beschreibung auf Abbildungen bevorzugter Ausführungsbeispiele, die nur erläuternden Charakter haben und keine Einschränkung des erfinderischen Konzepts darstellen. Weitere Einzelheiten, Merkmale und Vorteile ergeben sich aus der Beschreibung der Erfindung und den erfindungsgemäßen Ausführungsbeispielen in Verbindung mit den Abbildungen.

Es zeigen:
Fig. 1 den rückwärtigen Teil eines Baugruppenträgers mit einer Betriebsspannungsverteileinrichtung im Längsschnitt;
Fig. 2 eine Betriebsspannungsverteileinrichtung in perspektivischer Ansicht;
Fig. 3 eine Betriebsspannungsverteileinrichtung von der Seite und
Fig. 4 ein Teil einer Betriebsspannungsverteileinrichtung in perspektivischer Ansicht;
Fig. 5 den rückwärtigen Teil eines Baugruppenträgers mit einer Betriebsspannungsverteileinrichtung in perspektivischer Ansicht;
Fig. 6a eine in einen Baugruppenträger einsetzbare Baugruppe für die Betriebsspannungs- und/oder Signalverteilung zu einer an der Rückseite angeordneten Betriebsspannungs-und/oder Signalverteilungseinrichtung;
Fig. 6b eine in einen Baugruppenträger einsetzbare Baugruppe mit einem Abschnitt einer Betriebsspannungs-und/oder Signalverteilungseinrichtung;
Fig. 7a einen Baugruppenträger in perspektivischer Ansicht mit offener Rückseite;
Fig. 7b einen Baugruppenträger in perspektivischer Ansicht mit halboffener Rückseite und

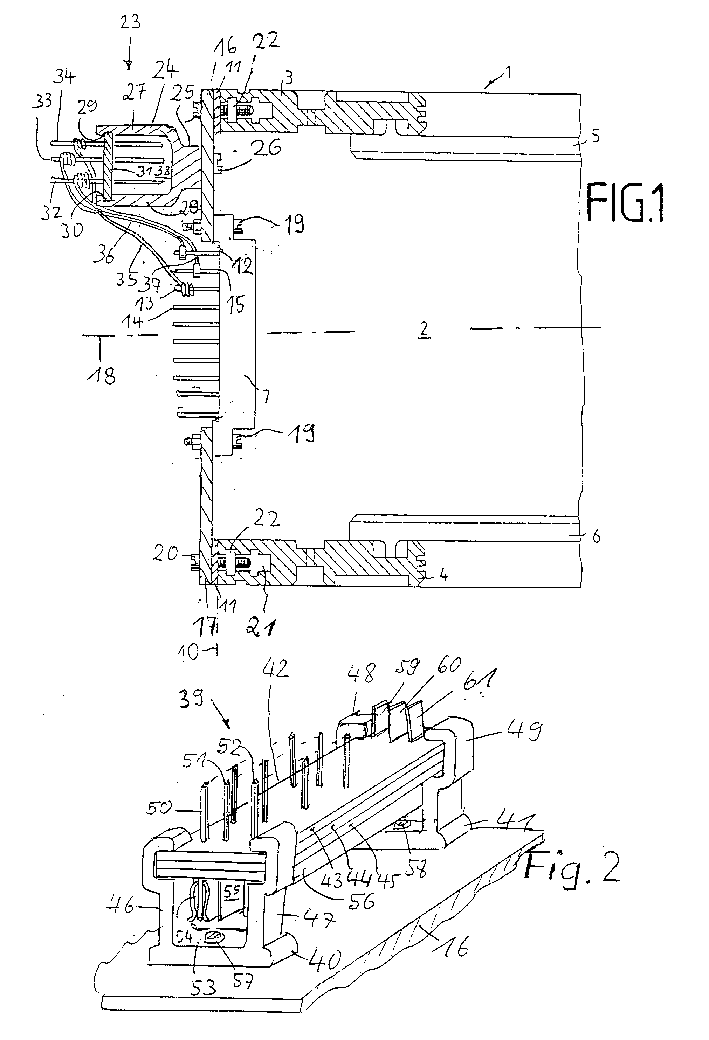

Ein Baugruppenträger 1 weist Seitenwände 2 auf, die durch Profilschienen miteinander verbunden sind. In Fig. 1 ist der rückwärtige Teil eines Baugruppenträgers 1 mit einer oberen Profilschiene 3 und einer unteren Profilschiene 4 dargestellt. Mit den Profilschienen 3, 4 sind Führungshalter 5, 6 verbunden, die nicht näher bezeichnete Längsnuten aufweisen, die die Ränder von Leiterplatten aufnehmen, die zu elektrischen oder elektronischen Baugruppen gehören. Diese nicht dargestellten Baugruppen werden in den Baugruppenträger 1 eingesetzt. Die Baugruppen sind an ihren rückseitigen Enden mit Messerleisten bestückt, die mit Federleisten 7 zusammenwirken, die am Baugruppenträger 1 befestigt sind. Die Profilschienen 3, 4 weisen Nuten 8, 9 auf, die nach der Rückseite offen sind. Die rückseitigen Flächen der Profilschienen 3, 4, die sich in einer Ebene 10 befinden, sind mit isolierenden Streifen 11 belegt.

Die Federleisten 7 weisen auf ihrer dem Baugruppeninneren abgewandten Seite neben anderen Pfosten auch Pfosten 12, 13, 14, 15 auf, die für die Stromversorgung der elektrischen Bauelemente auf den Baugruppen bestimmt sind.

Flache Metallschienen 16, 17 oder Z-förmig abgewinkelte Metallschienen verlaufen jeweils parallel zu den rückwärtigen Profilschienen 3, 4 und sind nahe an ihren Rändern jeweils an den Profilschienen unter Zwischenschaltung der isolierenden Streifen 11 angeschraubt. Die Metallschienen 16, 17 sind so an den Profilschienen 3, 4 befestigt, daß ihre der Mittelachse 18 des Baugruppenträgers 2 abgewandten Ränder auf gleichem Niveau wie die außen liegenden Seiten der Profilschienen 3 bzw. 4 liegen. Nahe an den der Mittelachse 18 zugewandten Rändern sind die Metallschienen 16, 17 mit den Federleisten 7 verbunden. Die Federleisten 7 sind an den Metallschienen 16, 17 je mit Schrauben 19 befestigt.

Zur Befestigung der Metallschienen 16, 17 an den Profilschiene 3, 4 sind ebenfalls Schrauben 20 vorgesehen, die durch nicht dargestellte Löcher in den Metallschienen 16, 17 in Nuten 21 der Profilschienen 3, 4 ragen. In den Profilschienen 3, 4 sind die Nuten mit kreuzförmigem Querschnitt ausgebildet und mit Gewindeleisten 22 versehen, in die die Schrauben 20 eingesetzt sind.

Für die Befestigung der einzelnen Teile untereinander sind insbesondere im Hinblick auf eine kosteneffiziente automatisierte Massenproduktion andere Verbindungsmittel als die Schrauben 19, 20 möglich, so zum Beispiel Preß-, Steck- oder Einrasteverbindungen, Vernietungen und Verklebungen sowie deren Konbinationen. Zusätzlich können Verbindungssicherungen eingesetzt werden wie Kabelbinder oder Stifte. Verklebungen können lösbar gestaltet sein.

In einem bevorzugten Ausführungsbeispiel ist mindestens eine Betriebsspannungs- und/oder Signalverteileinrichtung 23 am Baugruppenträger befestigt. Sie erstreckt sich über die gesammte oder einen Teil der Länge oder Breite des Baugeruppenträgers und ermöglicht den unkomplizierten Anschluß jeder beliebigen Baugruppe an jedem beliebigen Ort im Baugruppenträger. Befestigt wird die Betriebsspannungs- und/oder Signalverteileinrichtung am Rahmen des Baugruppenträgers.

Die Befestigung kann, wie oben bereits beschrieben, mittels mehrerer Methoden durchgeführt werden. Die Befestigungsmethode wird bei den jeweiligen Anwendungen der Erfindung (e.g. Ausführungsbeispielen) den jeweiligen Bedürfnissen und Produktionsvorgaben wie Stabilität, Umweltverträglichkeit, verwendete Produktionsstraße, etc. angepaßt.

In einer zweiten bevorzugten Ausführung ist wenigstens eine Betriebsspannungs- und/oder Signalverteileinrichtung 23 an wenigstens einer Metallschiene, z.B. der Metallschiene 16, befestigt. Bedarfsweise können beide Metallschienen 16, 17 ein oder mehrere Betriebsspannungs- und/oder Signalverteileinrichtungen 23 tragen.

In einer dritten bevorzugten Ausführung befinden sich ein oder mehrere Module der Betriebsspannungs- und/oder Signalverteileinrichtung direkt auf den Einschüben.

In diesem Fall ist der Baugruppenträger ohne Rückwand ausgebildet und die sich an vorherbestimmten Plätzen befindlichen Module der Betriebsspannungs- und/oder Signalverteileinrichtung können über Kontakete, z.B. Schleif- oder Steckkontakte, miteinander durchverbunden werden. Die Breite der Module der Verteileinrichtung können die der eigenen Einbaubreite oder andere Masse aufweisen. Die Kontakte zu den Messerleisten können auf die dem Fachmann wohlbekannten Weisen durchgeführt werden, so z.B. über Stecker, Klammern, Klemmen, etc.. Zudem können auf Baugruppen oder deren Messerleisten den Steckverbindern ähnliche oder identische Kontakte angebracht oder aufgebracht werden.

Bei einer vierten bevorzugten Ausführungsform ist eine der einzusetzenden Baugruppen gleichzeitig die Stromversorgung. Ihr Modul der Betriebsspannungs- und Signalverteilvorrichtung kann sich über die gesammte Breite des Baugruppenträgers erstrecken.

In diesem Ausführungsbeispiel können zusätzlich Abstützungen für die Module am Rahmen des Baugruppenhalters angebracht sein oder nachträglich angebracht werden. Zudem kann das Modul verschiebbar in einem Halter angebracht sein um die Baugruppe an jeder Stelle im Baugruppenhalter einsetzen zu können. Der Anschluß der Betriebsspannungsververteileinrichtung oder die Einspeisung von Signalen, z.B. Taktsignalen, kann direkt an der Baugruppe über Kabel oder Schleifer stattfinden.

Die Verwendung mehrerer Betriebspannungs-und/oder Signalverteileinrichtungen 23 ist von Bedeutung, wenn empfindliche, störungsentkoppelte Leitungen und nicht störungsentkoppelte Leitungen räumlich getrennt geführt werden sollen, so z.B. wenn eine 50 Hz 220 V Netzversorgungsspannung getrennt von einer Signalleitung geführtwerden soll oder wenn die räumliche Trennung gepulster Leitungen notwendig ist.

Die Betriebsspannungs- und/oder Signalverteileinrichtung 23 ist über Kabel oder Leitungen wenigstens an ein Stromversorgungsgerät oder einen Signalgeber, wie z. B. eine Meßeinrichtung, angeschlossen, die nicht näher dargestellt sind. Die Einspeisung kann von Meßapparaturen, von Baueinheiten oder dem Baugruppenträger erfolgen.

Von den Anschlußstellen für die Leitungen führen in der Betriebsspannungs- und/oder Signalverteileinrichtung Strombahnen zu weiter unten noch eingehend beschriebenen elektrisch leitenden Kontakten, von denen wiederum Leitungen zu den Kontakten auf den Rückseiten der Baugruppen verlaufen. In einem bevorzugten Ausführungsbeispiel handelt es sich bei den Kontakten an den Baugruppen um die Pfosten auf den Federleistenrückseiten. Ihnen sind Betriebsspannungen und Signaleingänge von Bauelementen auf den Steckbaugruppen zugeordnet. In einem weiteren bevorzugten Ausführungsbeispiel können durch Anbringung geeigneter Kontakte auf den Rückseiten der Baugruppen Betriebsspannungen und Signalleitungen direkt abgegriffen werden.

Die Betriebsspannungs- und/oder Signalverteileinrichtung 23 weist wenigstens eine mit dem sie tragenden Bauteil verbundene Halterung 24 auf. Die Halterung kann als elektrisch isolierednes Kunststoffteil mit U-förmigem Querschnitt ausgebildet sein. Weitere Formgebungen und andere Materialien sind möglich. So stellen Gummi, Keramiken, Holz oder andere nichtleitende Materialien Alternativen dar, die nach ihren elektrischen, mechanischen und ökologischen Eigenschaften ausgewählt werden. So weisen elastisch Materialien gute Eigenschaften bei Verpackung und Transport auf, während steifere Materialien eine höhere Präzession bei der Befestigung und dem Legen der Kontakte erlauben. Zudem kann der Halter als Kontakt oder Kontaktträger ausgebildet sein um die Verteileinrichtung an Betriebsspannungs- oder Signalquellen anzuschließen.

Für die Befestigung der Halter 24 an den ihn tragenden Bauelementen gelten die selben Überlegungen wie oben schon zweimal beschrieben. Exemplarisch wird die Verbindung eines isolierenden Halters 24 mit der Metallschiene 16 durch Schrauben 26 unter Verwendung einer Multilayer-Platte mit Einpreßstiften als ein bevorzugtes Ausführungsbeispiel ausführlich beschrieben (vgl. Abb. 1

Am Bodenabschnitt 25 ist die Halterung 24 an der Metallschiene 16 mittels einer Schraube 26 befestigt. Der U-förmige Querschnitt ist mit seiner Öffnung nach hinten gerichtet. Die Schenke 27, 28 der Halterung 24 weisen nahe an ihren freien Enden auf den Innenseiten Nuten 29, 30 auf, die auf gleichem Niveau einander gegenüberstehen. In die Nuten 29, 30 ist wenigstens eine Platte 31 eingesetzt, die Einpreßstifte 32, 33, 34 trägt.

Die Einpreßstifte 32, 33, 34 sind in Reihen angeordnet, die in Breitenrichtung des Baugruppenträgers 2 verlaufen, und ragen über die Enden der Schenkel 27, 28 hinaus. Bei mehreren parallelen Reihen von Einpreßstiften 32, 33, 34 ist die Platte 31 als Multilayer-Platte ausgebildet, die mehrere Leiterbahnen bzw. Leiterebenen aufweist, von denen je eine mit einer Reihe von Einpreßstiften 32 bis 34 verbunden ist. Die Einpreßstifte 32, 33, 34 sind jeweils an Stellen angeordnet, die in einer Ebene oder etwa in eine Ebene mit den Pfosten 12 bis 15 derjeweiligen Federleiste liegen, d. h. die Einpreßstifte 32 bis 34 befinden sich im genormten Rastermaß des Baugruppenträgers 2 an Stellen, die Fortsetzungen der jeweils Baugruppen zugeordneten Steckplätze im Baugruppenträger 2 bilden. Von den in Fig. 1 gezeigten, in einer vertikalen Reihe angeordneten Einpreßstiften verlaufen jeweils Leitungen 35, 36, 37 zu den Pfosten 13, 15, 12 der Federleiste 7. Die Leitungen 35 bis 37 sind in einer herkömmlichen Drahtanschlußtechnik mit den Pfosten 13, 15, 12 verbunden.

Die Halterung 24 kann sich über die gesamte Lange der Platte 31 erstrecken. Es ist aber auch möglich, zwei oder mehr kurze Halterungen an den Enden der Platte 31 bzw. in einem mittleren Abschnitt der Platte 31 anzuordnen.

Zwischen der Platte 27 und dem Bodenabschnitt 25 erstreckt sich ein freier Raum 38, in den Enden der Einpreßstifte 32 bis 34 ragen. Die in den Raum 38 ragenden Einpreßstiftenden jeweils einer Reihe können zur Erhöhung der Stromleitungskapazität durch Drähte oder andere Mittel miteinander verbunden werden. Es ist auch möglich, im Raum 38 andere Kontaktelemente und/oder elektrische Bauelemente wie Kondensatoren, Widerstände, Drosseln, Dioden und dergleichen vorzusehen, deren Leitungsanschlüsse z. B. in Lötanschlüße der Platte 31 eingesetzt sind.

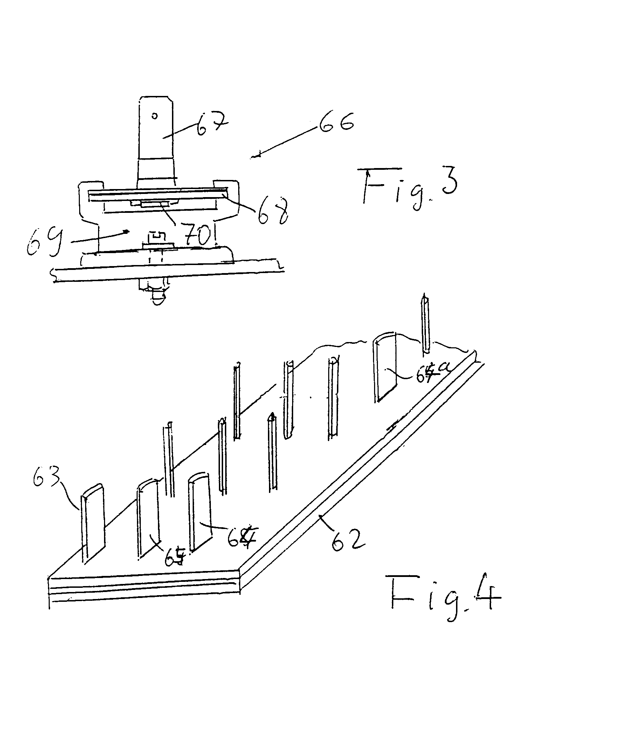

Die Fig. 2 zeigt eine Betriebsspannungs-und/oder Signalverteileinrichtung 39 in perspektivischer Ansicht. Die Betriebsspannungs- und/oder Signalverteileinrichtung 39 enthält zwei U-förmige Halterungen 40, 41, die eine Multilayer-Platte 42 mit drei verschiedenen Schichten 43, 44, 45 jeweils an den Enden halten, indem die Multilayer-Platte 42 in nicht näher bezeichnete Nuten der Schenkel 46, 47 bzw. 48, 49 der Halterungen 40, 41 eingesetzt ist.

Von der Multilayer-Platte 42 ragen Einpreßstifte über die Enden der Halterungen 40, 41 hinaus. In Fig. 2 sind nur jeweils drei Einpreßstifte 50, 51, 52 von je einer Reihe von Stiften bezeichnet, die längs der Multilayer-Platte 42 im genormten Rastermaß des Baugruppenträgers 2 angeordnet sind. Die eine, den Einpreßstift 50 enthaltende Stiftreihe ist beispielsweise über eine Leiterebene in der Platte mit einem positiven oder negativen Pol eines Stromversorgungsgeräts verbunden. Die mittlere, den Einpreßstift 51 enthaltende Stiftreihe ist z. B. über eine Leiterebene in der Multilayer-Platte 42 mit dem anderen Pol des Stromversorgungsgeräts verbunden, der geerdet sein kann. Die den Einpreßstift 52 enthaltende Stiftreihe weist Einpreßstifte in einer größeren Rastermaßteilung auf und führt ein Potential, das für andere Bauteile bestimmt ist.

In Fig. 2 sind verschiedene Möglichkeiten zur Erhöhung des für die Stromleitung verfügbaren Querschnitts dargestellt. Im allgemeinen wird nur eine Art von Mitteln zur Erhöhung der Leitungskapazität an einem Baugruppenträger eingesetzt, um die Gesamtzahl der notwendigen Bauelemente möglichst gering zu halten.

Die Stiftreihe mit dem Einpreßstift 50 ist so ausgebildet, daß die Einpreßstifte auch in den Raum 53 zwischen dem Trägerelement 42 und den anderen Bauelementen des Baugruppenzrägers, z.B. der Metallschiene 16, ragen. Auf die in den Raum 53 ragenden Stiftteile der Stiftreihe mit dem Einpreßstift 50 ist eine elastisch, leitende Schiene 54 aufgesteckt, die die Stifte miteinander verbindet. Derartige Schienen sind an sich bekannt. Sie können unter anderem auch zum Direktabgriff oder -einspeisung durch Kontaktelemente and den Baugruppen , wie in den bevorzugten Ausführungsbeispielen drei und vier beschrieben, verwendet werden.

Als weitere, bevorzugte Ausführungsform enthalten die Stiftreihen mit den Einpreßstiften 51, 52 jeweils flache Metallschienen 55, 56 als Basisteile, die im Raum 53 verlaufen. Auch diese sind in der oben beschriebenen Weise zum Direcktabgriff oder -einspeisung geeignet.

Es ist möglich, eine Multilayer-Platte 42 in Längsrichtung mit unterteilten Leiterebenen auszubilden, die jeweils für die Verteilung verschiedener Potentiale bestimmt sind.

Die Multilayer-Platte 40 hat vorzugsweise an ihren Enden elektrisch leitende Messer 59, 60, 61 befestigt, die an die jeweiligen Leiterbahnen angeschlossen sind und zum Anschluß der Betribsspannungs- und/oder Signalverteileinrichtung durch Kabelschuhe an Stromversorgungsgeräte oder Signal führenden Leitungen bestimmt sind. Die Messer 59, 60, 61 verlaufen mit ihren Breitseiten parallel zur Längsrichtung der Multilayer-Platte 42. Eine Multilayer-Platte 62 mit nicht näher bezeichneten Einpreßstiften und Messern 63, 64, 65, 65a ist auch in Fig. 4 dargestellt, wobei die Messer 64 an in Längsrichtung der Platte unterteilte Leiterebenen angeschlossen sind.

Fig. 3 zeigt eine Betriebsspannungs- und/oder Signalverteileinrichtung 66 von vorne mit einem für den Anschluß von Fasten-Steckschuhen bestimmten Messer 67, das mit einer nicht dargestellten Leiterbahn einer Multilayer-Platte 68 verbunden ist, die in einer Halterung 69 befestigt ist. Auf der Unterseite der Multilayer-Platte 68 ist ein Widerstand 70 angeordnet, der in den Raum zwischen der Multilayer-Platte 68 und den Boden der Halterung 69 ragt.

Die Halterungen 24, 40, 41, 69 können an den Metallschienen 16 bzw. 17 angeschraubt oder eingerastet sein. Die Leitungen 35, 36, 37 können an ihren Enden mit den jeweiligen Pfosten in Drahtwikkeltechnik, mit Steckschuhen oder durch Lötung verbunden sein.

Es versteht sich, daß obwohl die Beschreibung hauptsächlich anhand weniger bevorzugter Ausführungsbeispiele durchgeführt wurde, die dem Fachmann naheliegenden Lösungen mit eingeschlossen sind. So ist die Kontaktleiste keineswegs auf Einpreßstifte und -leisten der beschriebenen Art beschränkt sondern umfaßt ebenso Schraub-, Quetsch-, Klemm-, Steck- oder Lötverbindungen sowie deren Kombinationen.

Alternativen zu den Multi-Laverplatten stellen Träger aus anderen Materialien, wie z. B. Kunststoffen, dar.

Auch ist ersichtlich, daß als weiterer Vorteil der oben beschiebenen Erfindung einfach mechanische und elektrische Abschirmungen an den Rückseiten der Baugruppenhalter angebracht werden können. Sie können die Form einer Kiste aufweisen, die am Baugrupenhalter eingehängt oder angeschraubt werden.

Sie können aus Metall, Kunststoff oder anderen Werkstoffen sein um Abschirmung gegen HF-Störungen, mechanische Beeinträchtigungen, Verletzungsgefahr, Umwelteinflüsse usw. zu gewährleisten. Erfindungsgemäß eignet sich eine durchsichtige und zugleich leitende Kunststoffabschirmung besonders, weil sie neben der Schutzfunktion in Verbindung mit der Bertiebsspannungs- und/oder Signalverteilungsvorrichtung eine schnelle Sichtprüfung der Anschlüsse und deren Zustand zulassen.

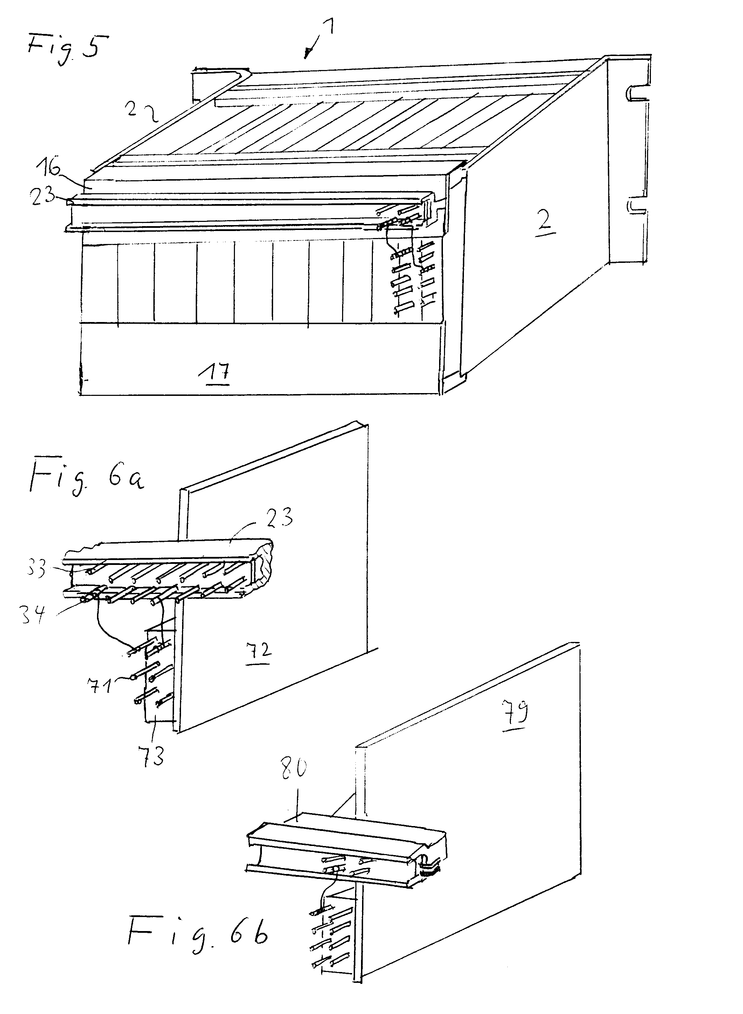

Die Fig. 5 zeigt einen Baugruppenträger 1 in perspektivischwer Ansicht auf die Rückseite. Die Seitenwände 2 sind an ihren vorderen Enden abgewinkelt und weisen nicht näher bezeichnete Aussparungen für Befestigungsschrauben auf, mit denen der Baugruppenträger an einem Gestell oder Schrank angeschraubt wird. Die Betriebsspannungs- und/oder Signalverteilungseinrichtung 23 erstreckt sich über die gesamte Baugruppenbreite. Die Federleisten 7 sitzen nebeneinander und beanspruchen eine Baugruppenteilung.

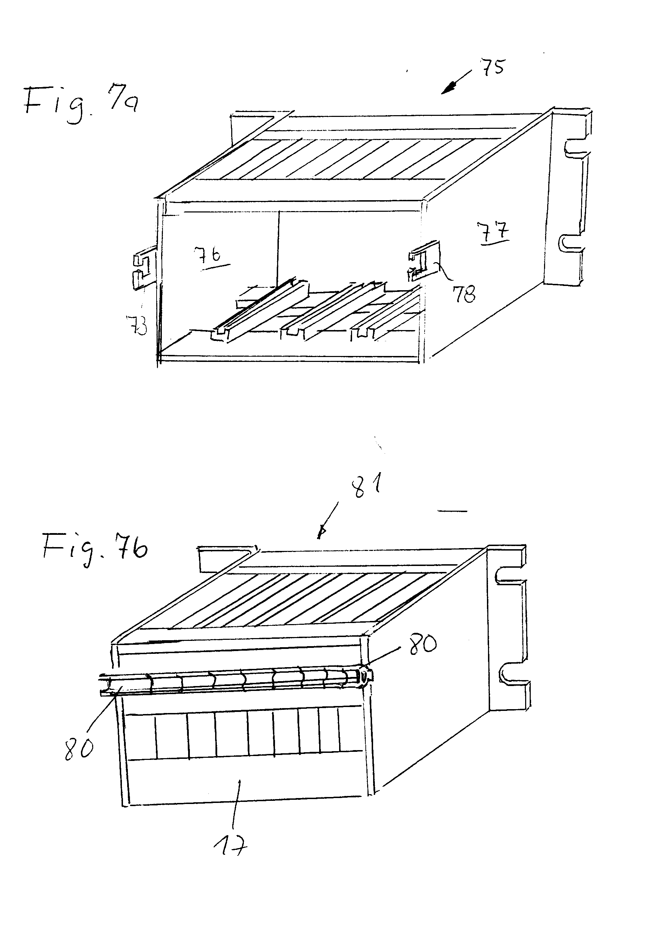

Die Betriebsspannungs- und/oder Signalverteilungseinrichtung eignet sich auch für Baugruppenträger, die zur Rückseite hin offen sind. In diesem Fall ist, wie in Fig. 7a dargestellt, die Betriebsspannungs- und/oder Signalverteilungseinrichtung 28 an den Seitenwänden 2 befestigt. Sie kann aber auch mit der Rückseite der obere oder unteren Profilschiene 3 bzw. 4 verbunden sein. Da bei dem Baugruppenträger gem. Fig. 7a keine Steckverbinderelemente an der Rückseite vorgesehen sind, werden, wie in Fig. 6a dargestellt, die Drahtverbindungen von den Einpreßstiften, z. B. 33, 34, direkt zu Anschlußstiften 71 verlegt, die von den jeweiligen Baugruppen, z. B. der in Fig. 6a gezeigten Baugruppe 72, ausgehen. Die Anschlußstifte 71 können zu einem Steckverbinder 73 gehören, der an einer nicht näher bezeichneten Leiterplatte der Baugruppe 72 befestigt ist. Auf der Leiterplatte befinden sich nicht näher dargestellte elektrische und/oder elektronische Bauelemente. Der in Fig. 7a dargestellte Baugruppenträger 75 enthält an den Seitenwänden 76, 77 Befestigungsmittel 78 für die Betriebsspannungs- und/oder Signalverteilungseinrichtung.

In Fig. 6b ist eine Baugrupe 79 dargestellt, an deren rückwärtigem Ende ein Abschnitt 80 einer Betriebsspannungs- und/oder Signalverteilungseinrichtung befestigt ist, die den oben erwähnten Aufbau mit Ausnahme der stirnseitigen Konstruktion hat.

Der Abschnitt 80 erstreckt sich über eine Teilung eines Baugruppenplatzes im Baugruppenträger 81, der in Fig. 7b dargestellt ist. Die Abschnitte 80, die an den Baugruppen befestigt sind, sind an ihren Stirnseiten jeweils nach Art von Steckverbindern aufgebaut, die beim Einstecken in den Baugruppenträger miteinander verbunden werden. Daher ist der Baugruppenträger 81 auf der Rückseite an seiner oberen Hälfte offen. Die Verbindung von den Stiften der Abschnitte 80 zu den Steckverbindern an der Rückseite des Baugruppenträgers 81 entspricht der oben im Zusammenhang mit Fig. 1 angegebenen Verbindung und ist in Fig. 7b nicht näher dargestellt.

## Patentansprüche

1. Baugruppenträger für elektrische oder elektronische Baugruppen und deren Baugruppen, die im Baugruppenträger in Führungshaltern einsetzbar sind, die an Profilschienen befestigt sind, die zwischen Seitenwänden des Baugruppenträgers verlaufen,
dadurch gekennzeichnet,
daß eine Betriebsspannungs- und/oder Signalverteileinrichtung (23; 39; 66) wenigstens eine Halterung (24; 40; 41; 65) aufweist, die wenigstens ein Halteelement (31; 42; 68) mit Kontaktelementen trägt, die entsprechend dem zu verteilenden Potential mit Leiterebenen verbunden und in der Nähe der jeweils mit Betriebsspannung und/oder Signalen zu versorgenden Anschlüssen angeordnet sind.

2. Baugruppenträger oder Baugruppen nach Anspruch 1,
dadurch gekennzeichnet, daß mindestens eine der Halterungen (24; 40;41; 65) der Verteileinrichtungen (23; 39; 66) elektrisch isolierend ist und daß mindestens ein Halteelement (31; 42; 68) der Betriebsspannungs- und/oder Signalverteileinrichtung (23; 39; 66) mit leitenden Einpreßstiften (32, 33, 34; 50, 51, 52) versehen ist.

3. Baugruppenträger oder Baugruppen nach Anspruch 1 oder 2,
dadurch gekennzeichnet,
daß an den rückseitigen Profilschienen der Baugruppenträger jeweils Metallschienen (16; 17) befestigt sind, die parallel zu den Profilschienen verlaufen und nahe an ihren äußeren Rändern je mit einer Profilschiene sowie nahe an ihren inneren Rändern mit Federleisten von Steckverbindern verbunden sind, die an den rückwärigen Seiten der Baugruppenträger für die Verbindung mit den Messerleisten der Baugruppen angebracht sind und ein Halteelement (31; 42; 68) dre Betriebspannungs-und/oder Signalverteileinrichtung (23; 39; 66), das mindestens mit einer der rückseitigen Metallschiene (16) verbunden ist .

4. Baugruppenträger oder Baugruppen nach einem oder mehreren der vorhergehenden Ansprüche,
dadurch gekennzeichnet,
daß die den Betriebsspannungs- und/oder Signalverteileinrichtung (23; 39; 66) zugeordneten Kontakte als Federleisten (7) zum Einbringen der Messerkontakte der Baugruppen ausgebildet sind.

5. Baugruppenträger oder Baugruppen nach einem oder mehreren der vorhergehenden Ansprüche,
dadurch gekennzeichnet,
und daß die jeweiligen Leiterebenen der Verteilvorrichtungen (23; 39; 66) mit wenigstens einer nahe am Ende der Platte angebrachten Anschlußstelle (59, 60, 61) für wenigstens eine Leitung verbunden sind, die für den Anschluß an ein Stromversorgungsgerät oder eine Signalzuführung bestimmt ist.

6. Baugruppenträger oder Baugruppen nach einem oder mehreren der vorhergehenden Ansprüche,
dadurch gekennzeichnet,
daß die von Halterungen (24; 40; 41; 65) getragenen Halteelementen (31; 42; 68) als eine Multilayer-Platte (31) ausgebildet sind, die wenigstens zwei parallele Reihen von Einpreßstiften (32, 33, 34) enthält, die in dem Raum hinter den Profilschienen (3, 4) über die Halterung (24) hinausragen und daß die Halterungen (24) einen freien Raum zwischen der Multilayer-Platte (42) und einem Bodenabschnitt (25) aufweist, in den die Einpreßstifte (32, 33, 34) ragen.

7. Baugruppenträger oder Baugruppen nach einem oder mehreren der vorhergehenden Ansprüche,
dadurch gekennzeichnet,
daß die in den freien Raum (53) zwischen der Multilayer-Platte (42) und dem Bodenabschnitt bzw. der flachen Metallplatte (16) ragenden Teile der Einpreßstifte (51) durch eine leitende Aufsteckschiene miteinander verbunden sind.

8. Baugruppenträger oder Baugruppen nach einem oder mehreren der vorhergehenden Ansprüche,
dadurch gekennzeichnet,
daß die in die Multilayer-Platte (42) eingefügten Einpreßstifte (51, 52) von einer flachen Metallschiene (55, 56) vorspringen, die im Raum (53) zwischen dem Bodenabschnitt der Halterungen (40, 41) bzw. der Metallplatte (16) und der Multilayer-Platte (42) verläuft.

9. Baugruppenträger oder Baugruppe nach einem oder mehreren der vorhergehenden Ansprüche,
dadurch gekennzeichnet,
daß die Leiterebenen der Multilayer-Platte (42) je mit einem am Rand der Multilayer-Platte angeordneten Messer (59, 60, 61) für den Anschluß einer zu einem Stromversorgungsgerät verlaufenden Leitung verbunden sind.

10. Baugruppenträger oder Baugruppe nach einem oder mehreren der vorhergehenden Ansprüche,
dadurch gekennzeichnet,
daß die Leiterebenen der Multilayer-Platte (62) in Längsrichtung unterteilt sind, und daß die unterteilten Leiterebenen je mit Messern (64, 64a) für den Anschluß von Steckelementen von Leitungen versehen sind.
